Europäisches Patentamt

European Patent Office

Office européen des brevets

(19)

(11) Numéro de publication: **0 262 013**
**B1**

(12) **FASCICULE DE BREVET EUROPEEN**

(45) Date de publication du fascicule du brevet: **23.01.91**

(51) Int. Cl.⁵: **G 11 C 7/06**

(21) Numéro de dépôt: **87401936.7**

(22) Date de dépôt: **27.08.87**

(54) **Amplificateur de lecture.**

(30) Priorité: **29.08.86 FR 8612221**

(43) Date de publication de la demande:
**30.03.88 Bulletin 88/13**

(45) Mention de la délivrance du brevet:
**23.01.91 Bulletin 91/04**

(84) Etats contractants désignés:
**DE FR GB IT NL SE**

(56) Documents cités:
**EP-A-0 143 591**
**EP-A-0 175 880**
**EP-A-0 185 451**
**GB-A-2 070 372**

(73) Titulaire: **BULL S.A.**
**121 avenue de Malakoff P.B. 193.16**
**F-75764 Paris Cédex 16 (FR)**

(72) Inventeur: **Schoellkopf, Jean-Pierre**
**1, place Condorcet**
**F-38000 Grenoble (FR)**
Inventeur: **Boyer Chammard, Yann**
**18, rue de la Saussière**
**F-92100 Boulogne Billancourt (FR)**

Courier Press, Leamington Spa, England.

## Description

L'invention concerne un dispositif d'amplification, couramment appelé amplificateur de lecture, servant à amplifier la différence de tension apparaissant entre deux lignes et représentant un bit d'information.

De tels amplificateurs servent aussi à stabiliser les niveaux de tension des deux lignes de bit.

Les lignes de bits peuvent être les lignes de sortie d'une cellule mémoire délivrant des niveaux de tension nécessitant une amplification. L'amplificateur de lecture selon l'invention peut s'appliquer aussi bien à des cellules mémoire statiques que dynamiques.

Les lignes de bits peuvent être également reliées aux lignes de sorties d'un circuit logique faisant partie d'un opérateur appartenant par exemple à une unité centrale de traitement d'un ordinateur.

L'amplificateur selon l'invention est particulièrement bien adapté pour amplifier les signaux de sortie de circuits réalisés en technologie CMOS.

De façon classique, les amplificateurs de lecture doivent maintenir les deux lignes de bit à des niveaux de tension prédéterminés et stables représentatifs d'une valeur binaire correspondante. Habituellement l'un de ces niveaux correspond à la tension de masse du circuit tandis que l'autre niveau est celui d'une source de tension d'alimentation.

Les amplificateurs de lecture doivent satisfaire d'une part à une contrainte de rapidité de fonctionnement et d'autre part ils doivent être conçus pour réduire leur consommation le plus possible.

Le brevet US-A-4551641 décrit un dispositif d'amplification en technologie CMOS constitué par un premier amplificateur réalisé à l'aide de transistors NMOS montés en croix qui, sous l'action d'un signal de commande, réalise la mise à la masse de la ligne de bit ayant la tension la plus proche de la tension de masse. Sous l'action d'un second signal de commande, un second amplificateur utilisant des transistors PMOS montés en croix a pour effet de mettre en communication la deuxième ligne de bit avec la source d'alimentation. Les signaux de commande des deux amplificateurs sont des signaux d'horloge déphasés entre eux. Ce dispositif réalise bien l'amplification des lignes de bits mais il exige la présence de deux signaux d'horloge dont le déphasage doit être suffisant pour activer le second amplificateur lorsque la première ligne de bit est suffisamment déchargée. En effet, si l'amplificateur à transistors PMOS était déclenché trop tôt, avant que la première ligne de bit soit suffisamment déchargée, les deux amplificateurs créeraient un chemin de court-circuit entre la source d'alimentation et la masse. Ceci constitue un inconvénient important dans le cas notamment où plusieurs dispositifs d'amplification sont utilisés pour amplifier la sortie d'un registre ou d'un opérateur comprenant un grand nombre de lignes de bit, chaque paire de lignes de bit étant reliée à un tel dispositif d'amplification commandé par des signaux provenant d'une horloge unique. Dans une telle application, tous les amplificateurs à transistors PMOS sont activés simultanément et il faut donc prévoir un retard suffisamment important entre cette activation et celle des amplificateurs à transistors NMOS de façon à éviter le court-circuit précité dans n'importe quelle paire de lignes de bit. De plus, ce retard doit tenir compte également de la dispersion des propriétés des circuits inhérente à la fabrication. Ces remarques montrent que l'on sera donc amené à exagérer le déphasage entre les activations des deux amplificateurs, ce qui entraînera nécessairement un fonctionnement moins rapide de l'amplification. Sinon, on augmentera le risque de créer des chemins de court-circuit entre l'alimentation et la masse, donc la consommation.

L'invention a pour but d'éviter les inconvénients précités et pour cela propose un dispositif d'amplification selon lequel le second amplificateur n'est pas commandé par un signal d'horloge mais par un signal dérivé de l'état des tensions sur les lignes de bits.

Plus précisément l'invention a pour objet un dispositif pour amplifier la différence de tension entre deux lignes de bit, ledit dispositif étant associé à une source de tension d'alimentation et comprenant un premier amplificateur sensible aux tensions desdites lignes de bit et qui, lorsqu'il est activé par un signal de commande, met en communication la ligne de bits ayant a plus faible tension (la plus forte tension) avec la borne de plus faible potentiel (de plus forte potentiel) de ladite source de tension, ledit dispositif étant caractérisé en ce qu'il comprend un circuit de détection délivrant un signal de sorte lorsque la tension d'une des lignes de bit est inférieure (supérieure) à une valeur déterminée et en ce que ledit signal de sortie commande l'activation d'un second amplificateur sensible auxdites tensions qui, lorsqu'il est activé, met en communication la ligne de bit ayant la tension la plus élevée (la plus faible) avec la borne de plus fort potentiel (de plus faible potentiel) de ladite source d'alimentation.

L'invention propose également un mode de réalisation utilisant la technologie CMOS.

Selon un autre aspect, l'invention concerne également un dispositif permettant d'asservir l'activation du premier amplificateur aux signaux de sélection de la cellule mémoire ou de l'opérateur dont la sortie est amplifiée par des dispositifs selon l'invention.

Selon un autre aspect, le dispositif d'amplification selon l'invention est associé à un circuit permettant une précharge des lignes de bit asservie à la fin de l'activation du premier amplificateur.

D'autres caractéristiques et détails de réalisation apparaîtront dans le mode de réalisation préférentiel décrit dans la description qui va suivre:

La figure 1 représente schématiquement un dispositif d'amplification selon l'invention.

La figure 2 représente un mode de réalisation en technologie CMOS des circuits d'amplification et d'auto-déclenchement du dispositif d'amplification selon l'invention.

La figure 3 représente un mode de réalisation d'un circuit de déclenchement du dispositif d'amplification selon l'invention.

La figure 4 représente un circuit de précharge des lignes de bit faisant partie du dispositif d'amplification selon l'invention.

Les figures 5 et 6 représentent des chronogrammes permettant d'expliquer le fonctionnement selon deux variantes de réalisation du dispositif d'amplification selon l'invention.

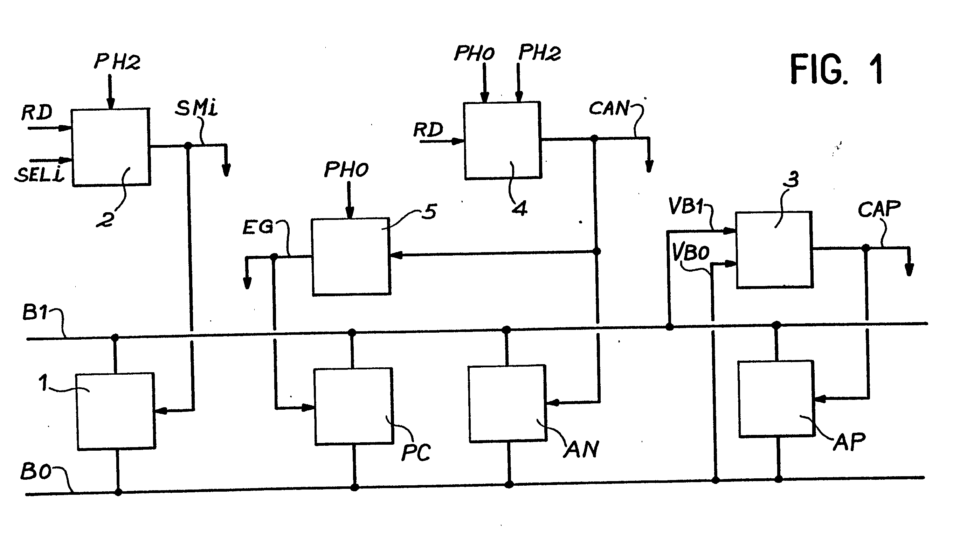

La figure 1 montre de façon schématique les éléments essentiels constituant le dispositif d'amplification. La figure montre également comment ce dispositif coopère avec un point mémoire ou un circuit logique binaire.

La figure 1 représente les lignes de bits B0, B1 qui sont reliées aux bornes de sortie de l'unité binaire 1 qui est par exemple une bascule faisant partie d'un registre.

L'unité binaire 1 pourrait également être le circuit de sortie associé à un bit d'un opérateur numérique. Pour simplifier la suite de l'exposé, nous nous contenterons de désigner cette unité binaire par l'expression "point mémoire".

Le point mémoire 1 est sélectionné par le signal SMi issu d'un circuit de sélection 2 recevant un signal de commande de lecture RD, un signal d'horloge PH2 et éventuellement un signal de sélection de registre SELi qui est utilisé si le point mémoire 1 est une bascule appartenant à un banc de registre. Dans le cas où le registre i du banc est sélectionné, le signal SELi devient actif, ce qui sélectionne toutes les bascules du registre i par le signal SMi. La sélection n'est effective que sous la commande du signal de lecture RD et pendant la phase de lecture imposée par le signal d'horloge PH2. Le circuit de sélection 2 ne pose pas de problème de réalisation particulier. Il est avantageusement réalisé de façon classique à l'aide de portes logiques en technologie CMOS.

Le point mémoire 1 et le circuit de sélection 2 sont mentionnés dans le but de montrer le contexte dans lequel est placé le dispositif d'amplification de l'invention. Le dispositif d'amplification proprement-dit est constitué par un premier amplificateur AN relié aux lignes de bit B0, B1 et activé par un signal de commande CAN. L'activation de l'amplificateur AN a pour effet de décharger la ligne de bit B0 ou B1 ayant le plus faible potentiel. Par exemple si le circuit travaille entre les tensions 0 et 5 volts, l'amplificateur AN mettra en communication la ligne de plus faible potentiel avec la masse.

Le signal de commande CAN est généré par le circuit de commande 4 en réponse au signal de commande de lecture RD pendant la phase de lecture déterminée par le signal d'horloge PH2.

Un second amplificateur AP est connecté également aux lignes de bit B0, B1 et reçoit le signal de commande CAP. Lorsqu'il est activé, cet amplificateur AP a pour effet de charger la ligne ayant le plus fort potentiel. Par exemple, si la tension d'alimentation est de 5 volts, la ligne de plus fort potentiel sera chargée à 5 volts par l'amplificateur AP.

Le signal de commande CAP du second amplificateur AP est fourni par un circuit de détection 3 dont les entrées sont reliées aux deux lignes de bit B0, B1. Le détecteur 3 active le signal CAP lorsque l'une des tensions VB0, VB1 des lignes de bits B0, B1 est en-dessous d'un seuil de tensions prédéterminées. Ainsi, grâce au détecteur 3, le second amplificateur AP est auto-déclenché, c'est-à-dire déclenché automatiquement lorsque le premier amplificateur a travaillé suffisamment pour décharger la ligne de bit de plus faible potentiel. L'échelonnement des déclenchements des deux amplificateurs AN, AP est indispensable pour garantir une amplification stable de la différence de la tension relativement faible présente initialement entre les deux lignes de bit.

De façon classique, le dispositif d'amplification comprend également un circuit de précharge PC destiné à précharger les deux lignes de bit à une tension déterminée avant une sélection du point mémoire pour sa lecture. Le circuit de précharge PC est actionné par le signal de commande EG issu d'un circuit de commande de précharge 5. Ce circuit de commande de précharge reçoit le signal de commande CAN du premier amplificateur AN. Ce circuit reçoit également le signal d'horloge PH0 qui détermine la phase de précharge. Ce signal d'horloge PH0 est également appliqué au circuit de commande 4 du premier amplificateur AN et a pour effet de désactiver le signal de commande CAN du premier amplificateur AN. Le circuit de commande de précharge 5 a pour rôle d'asservir l'activation de la précharge au signal CAN de sorte que le signal de commande de précharge ne soit actif qu'après la disparition du signal de commande de l'amplificateur AN.

Le fonctionnement du dispositif de la figure 1 est le suivant. Nous nous plaçons dans le cas où les circuits sont alimentés par une source de tension positive de 5 volts par exemple. Dès l'apparition du signal PH0, le signal CAN est mis à zéro par le circuit 4. Dès que le signal CAN est à zéro, le circuit 5 délivre le signal de commande de précharge EG qui active le circuit de précharge PC. Les lignes de bit B0, B1 sont alors chargées à la même tension de précharge. Durant la phase de lecture définie par le signal PH2, si les signaux RD et SELi sont appliqués au circuit de commande de sélection 2, le point mémoire 1 est sélectionné par le signal SMi. En fonction de la valeur binaire mémorisée dans le point mémoire 1, l'une des lignes de bit prendra une tension supérieure à la tension de l'autre ligne de bit. D'autre part, le circuit de commande 4 provoquera l'activation du premier amplificateur AN. Il en résulte alors une décharge de la ligne de bit qui avait la plus faible tension. Lorsque la tension de cette ligne descend en dessous d'une valeur seuil, cet état est détecté par le circuit 3 qui active alors le second amplificateur AP. La ligne de bit ayant la plus forte tension est alors chargée à la tension d'alimentation par le second amplificateur. Ainsi grâce à l'action conjuguée des deux amplificateurs l'une des lignes de bit aura la tension nulle tandis que l'autre ligne de bit sera portée à la tension d'alimentation. Cet état subsistera jusqu'à l'apparition d'une nouvelle phase de précharge PH0.

Tout en restant dans le cadre de l'invention, on peut concevoir également de permuter les rôles des deux amplificateurs AP et AN. Selon cette variante, l'amplificateur AP est d'abord activé par le signal CAN. Lorsque la tension de la ligne ayant le plus fort potentiel dépasse une valeur de seuil, le détecteur active alors l'amplificateur AN.

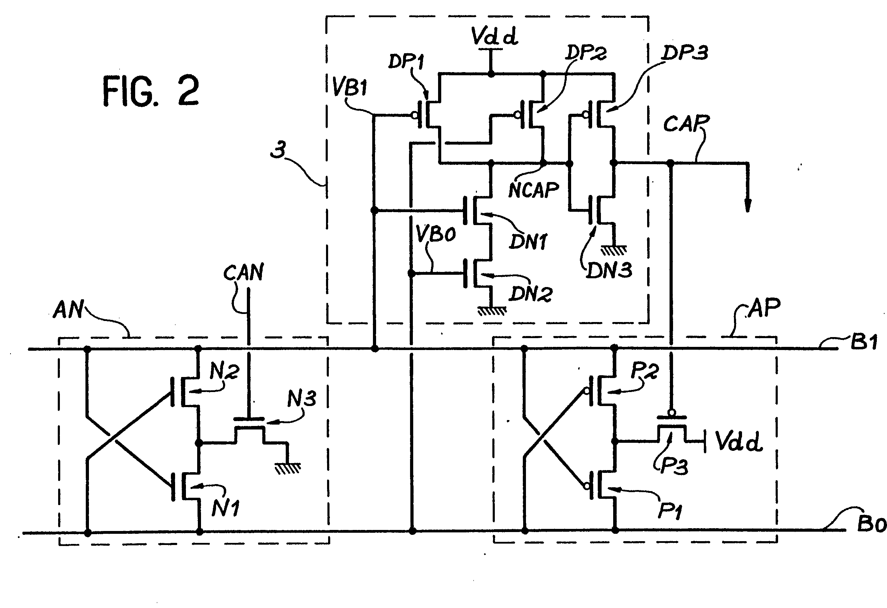

La figure 2 représente un mode de réalisation détaillée du premier amplificateur AN, du second amplificateur AP et du détecteur 3 qui le commande. Les circuits sont réalisés au moyen de transistors à effet de champs tels que des transistors MOS. Plus précisément la réalisation est faite en technologie CMOS. Par convention, les transistors PMOS se distinguent des transistors NMOS par un petit rond accolé à leur grille.

Les deux amplificateurs AN et AP utilisent un montage classique. Le premier amplificateur AN est réalisé au moyen de trois transistors NMOS. Un premier transistor N1 a son drain relié à une des lignes de bit B0, un second transistor N2 a son drain relié à l'autre ligne de bit B1 et les sources des deux transistors N1, N2 sont reliées au drain d'un troisième transistor N3 dont la source est reliée à la masse. La grille du premier transistor est reliée à la seconde ligne de bit B1 tandis que la grille du deuxième transistor est reliée à la première ligne de bit B0. La grille du troisième transistor N3 reçoit le signal de commande CAN. Le second amplificateur AP utilise des transistors PMOS montés de façon analogue. Un premier transistor P1 a son drain relié à la première ligne de bit B0, un second transistor P2 a son drain relié à la première ligne de bit B0, les sources de ces deux transistors P1, P2 sont reliées au drain d'un troisième transistor P3 dont la source est reliée à la tension d'alimentation Vdd. Le troisième transistor P3 reçoit sur sa grille le signal de commande CAP.

Le détecteur 3 est constitué par une porte logique ET réalisée en technologie CMOS. Pour réaliser une porte ET on utilise une porte "NON ET" CMOS suivie d'un inverseur CMOS. Comme représenté à la figure 2, la porte "NON ET" est constituée par les quatre transistors DP1, DP2, DN1, DN2 montés de façon classique. Deux transistors PMOS DP1, DP2 sont montés en parallèle, leurs sources étant reliées à la tension d'alimentation positive Vdd. Deux transistors NMOS DN1, DN2 sont montés en série, le drain du transistor DN1 étant relié aux drains des transistors DP1 et DP2, la source du transistor DN2 étant reliée à la masse. Les grilles des transistors DN1 et DP1 sont reliées à la ligne B1, celles des transistors DN2 et DP2 à la ligne B0. L'inverseur est réalisé par les deux transistors complémentaires DP3, DN3, selon un montage classique.

Le fonctionnement du circuit de la figure 2 est le suivant. Si l'on suppose qu'au moment de la commande du premier amplificateur AN la tension de la ligne de bit B0 est inférieure à celle de la ligne de bit B1, le transistor à canal n N1 est davantage conducteur que le transistor N2. Il en résulte que la tension de la ligne B0 décroît plus rapidement que celle de la ligne B1. Lorsque la tension de la ligne B0 est inférieure à la tension de seuil du transistor à canal n DN2 du détecteur 3, ce dernier transistor est bloqué. D'autre part, la tension de la ligne B0 appliquée à la grille du transistor complémentaire DP2 rend ce dernier transistor à l'état passant. La tension NCAP du drain de ce transistor augmente alors vers la tension d'alimentation Vdd. Il en résulte que la tension de sortie CAP de l'inverseur DP3, DN3 décroît vers 0. Le transistor à canal p P3 de l'amplificateur AP devient alors conducteur et compte tenu de la différence de tension présente entre les lignes de bits B0, B1, le transistor à canal p P2 deviendra conducteur tandis que le second transistor à canal p P1 sera moins conducteur. La tension VB1 de la ligne de bit B1 augmentera donc vers la tension d'alimentation Vdd. Simultanément le transistor à canal p P1 deviendra de moins en moins conducteur. Finalement la ligne de bit B1 sera chargée à la tension d'alimentation Vdd, tandis que la ligne de bit B0 sera complètement déchargée.

Un fonctionnement analogue est obtenu dans l'hypothèse où la tension de la ligne de bit B1 est inférieure à la ligne de bit B0. Dans ce dernier cas, le transistor à canal p DP1 du détecteur 3 devient conducteur lorsque la tension VB1 de la ligne de bit B1 est inférieure à la tension de seuil de ce transistor. De même, le transistor à canal n DN1 sera bloqué. Il en résulte comme précédemment l'activation du second amplificateur AP. Finalement la tension VB1 devient nulle et la tension VB0 devient égale à la tension d'alimentation Vdd.

Dans la mesure où les fonctionnements des amplificateurs AN et AP ne seraient pas fondamentalement modifiés, leurs réalisations pourraient subir des modifications mineures pour des raisons purement technologique. En particulier, on peut remplacer le transistor N3 par deux transistors de type n en parallèle. De même les sources des transistors P1 et P2 pourraient être reliés séparément à la source de tension par l'intermédiaire, respectivement, de deux transistors de type p commandés par le même signal CAP.

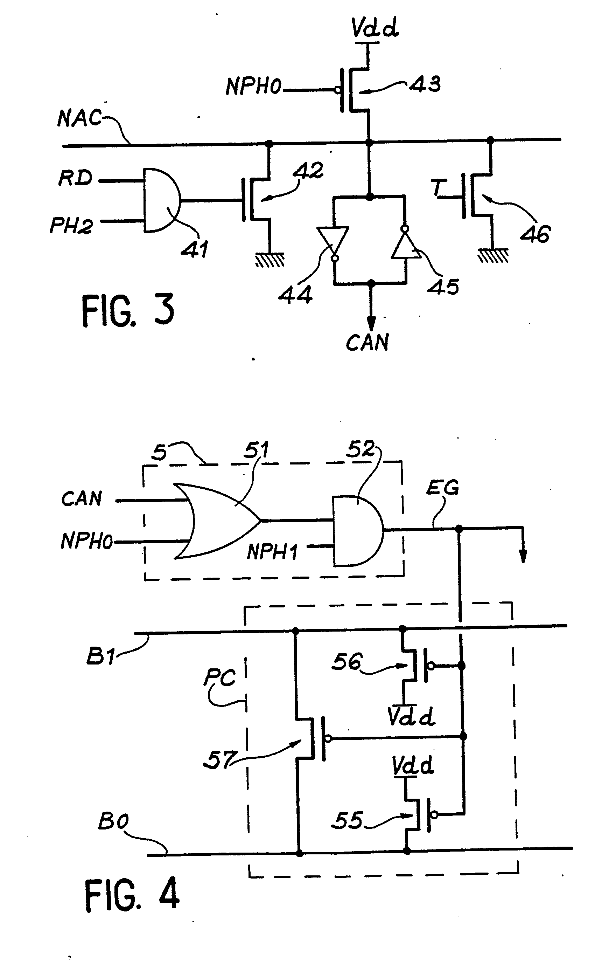

La figure 3 représente un mode de réalisation du circuit de commande 4 du premier amplificateur AN. Ce circuit comprend une porte ET 41 recevant le signal de commande de lecture RD et le signal d'horloge PH2 commandant la phase de lecture. La sortie de cette porte ET 41 est reliée à la grille d'un transistor NMOS 42 dont la source est reliée à la masse et dont le drain est relié à une ligne NAC. Cette ligne NAC est reliée à l'entrée d'une bascule constituée par deux inverseurs CMOS montés en tête-bêche 44, 45. La sortie de cette bascule délivre le signal de commande CAN du premier amplificateur AN. La ligne NAC est également reliée au drain d'un transistor PMOS 43 dont la source est reliée à la tension d'alimentation Vdd et dont la grille reçoit le signal NPH0. La ligne NAC peut également être reliée au drain d'un ou plusieurs transistors NMOS 46 dont la grille reçoit un signal T.

Ce circuit de commande fonctionne de la façon suivante. Pendant la phase de précharge, le signal d'horloge PH0 est actif et son signal complémentaire NPH0 appliqué à la grille du transistor 43 rend ce dernier conducteur. Il en résulte que la ligne NAC se charge à la tension d'alimentation Vdd. La sortie de la bascule 44, 45 prend alors la valeur 0 logique correspondant à une tension nulle et le premier amplificateur AN n'est pas activé. Pendant la phase de lecture, le signal d'horloge PH2 est actif. Si en même temps le signal RD est actif, le signal de sortie de la porte ET 41 rend conducteur le transistor 42, ce qui décharge la ligne NAC. Il en résulte que la bascule 44, 45 change d'état et son signal de sortie CAN prend la valeur 1 logique correspondant à la tension Vdd, activant ainsi le premier amplificateur AN.

La commutation du transistor 42, la décharge de la ligne NAC et le changement d'état de la bascule 44, 45 nécessite un certain délai qui a pour effet de retarder l'activation du premier amplificateur par rapport à l'apparition du signal d'horloge PH2. Ainsi l'amplificateur AN sera activé un certain temps après la sélection du point mémoire 1, ce qui laisse un temps suffisant pour que les lignes de bit B0, B1 présentent une différence de tension qui permette un fonctionnement correct du premier amplificateur AN.

Le transistor 46 est prévu pour permettre l'activation des amplificateurs AN en dehors du cas d'une lecture. Ceci peut être utile si on veut utiliser les lignes de bit B0, B1 simplement comme lignes de transfert sans sélection d'un point mémoire associé à ces lignes.

La figure 4 représente un mode de réalisation d'un dispositif permettant la précharge des lignes de bit B0, B1. Ce dispositif se compose du circuit de précharge proprement-dit PC et d'un circuit de commande 5.

Le circuit de précharge PC est constitué par trois transistors à effet de champs à canal p 55, 56, 57. Les deux transistors 55 et 56 ont leur source reliée à une borne d'alimentation de tension positive, Vdd par exemple. Les drains des transistors 55 et 56 sont reliés respectivement aux deux lignes de bit B0, B1. Le troisième transistor 57 a ses électrodes de courant reliées aux deux lignes de bit B0, B1. Les trois transistors 55 56 et 57 reçoivent sur leur grille le signal EG issu du circuit de commande 5.

Le fonctionnement du circuit de précharge PC est très simple. Lorsque le signal EG prend la valeur 1 logique correspondant à la tension Vdd, les trois transistors 55, 56, 57 sont bloqués. Lorsque le signal EG prend la valeur 0 logique, les trois transistors conduisent. Il en résulte que les lignes de bit B0, B1 vont se charger à la tension d'alimentation Vdd, le transistor 57 garantissant une égalisation des tensions des deux lignes.

La précharge des lignes de bit B0 et B1 ne doit pas s'opérer lorsque le premier amplificateur AN est encore actif car sinon cela provoquerait un chemin de court-circuit entre la tension positive Vdd et la masse via l'un des transistors 55 ou 56 du circuit de précharge PC et l'un des transistors N1 ou N2 à l'état passant du premier amplificateur AN. Dans ce but le circuit de commande de précharge 5 comprend une porte OU 51 recevant sur ses deux entrées le signal CAN et le signal complémentaire NPH0 du signal d'horloge PH0 servant à déclencher la phase de précharge. La sortie de la porte OU 51 est reliée à l'une des deux entrées d'une porte ET 52 dont l'autre entrée reçoit le signal complémentaire NPH1 d'un autre signal d'horloge PH1, succédant au signal PH0. La sortie de la porte ET 52 fournit le signal EG appliqué aux grilles des transistors du circuit de précharge PC.

Le circuit de commande 5 permet donc l'activation du circuit de précharge PC alors que le signal d'horloge PH0 est actif mais à condition seulement que le signal CAN soit déjà inactif. Ce dispositif permet donc le déclenchement de la précharge le plus tôt possible au début de la phase de précharge PH0, tout en tenant compte du retard pour la désactivation du signal CAN provoqué par les temps de réponse du transistor 43 et de la bascule 44, 45 décrit à la figure 3.

La porte ET 52 qui reçoit le signal NPH1 a été mentionnée pour tenir compte du cas où le dispositif d'amplification est utilisé dans une unité centrale de traitement d'ordinateur travaillant en quatre phases d'horloge. Plus précisément, la première phase d'horloge PH0 correspond à une phase de désactivation des amplificateurs de chemin de données et à la précharge de la ligne de contrôle NAC mentionnée à la figure 3. La phase PH1 est une phase dédiée à la précharge des lignes de bit du chemin de donnée. La phase PH2 active la sélection des points mémoire ou des opérateurs numériques. Enfin une quatrième phase PH3 correspond à une phase d'amplification des signaux de sortie de ces points mémoires ou de ces circuits logiques.

Il est à noter que l'on pourrait précharger les lignes de bit à des tensions inférieures à la tension positive Vdd de la source d'alimentation. On pourrait même simplifier le circuit de précharge en ne conservant que le seul transistor d'égalisation 57 car la sélection d'un point mémoire en lecture est toujours suivie d'une charge à la tension positive d'alimentation d'une des lignes de bits. L'activation du seul transistor d'égalisation 57 après une telle précharge placerait chacune des lignes de bit à une tension moitié de la tension d'alimentation.

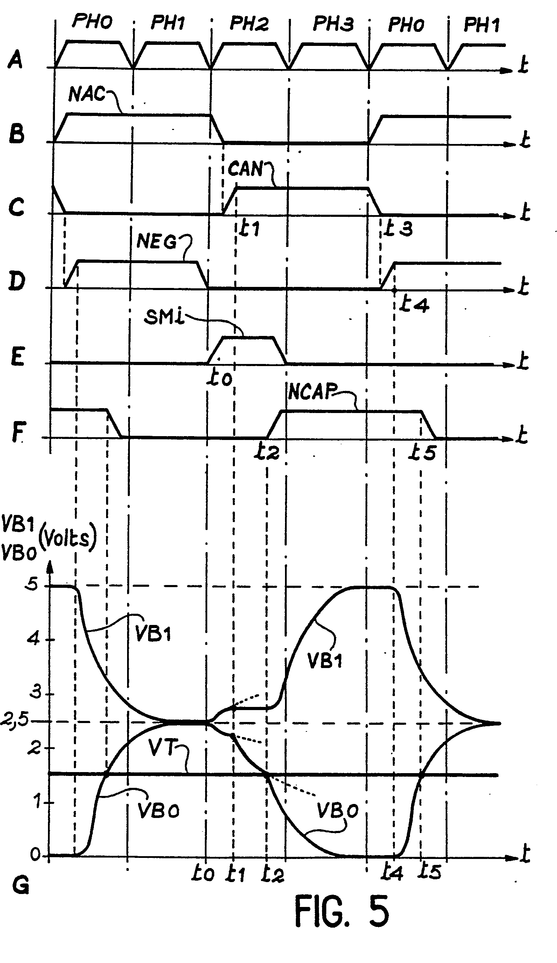

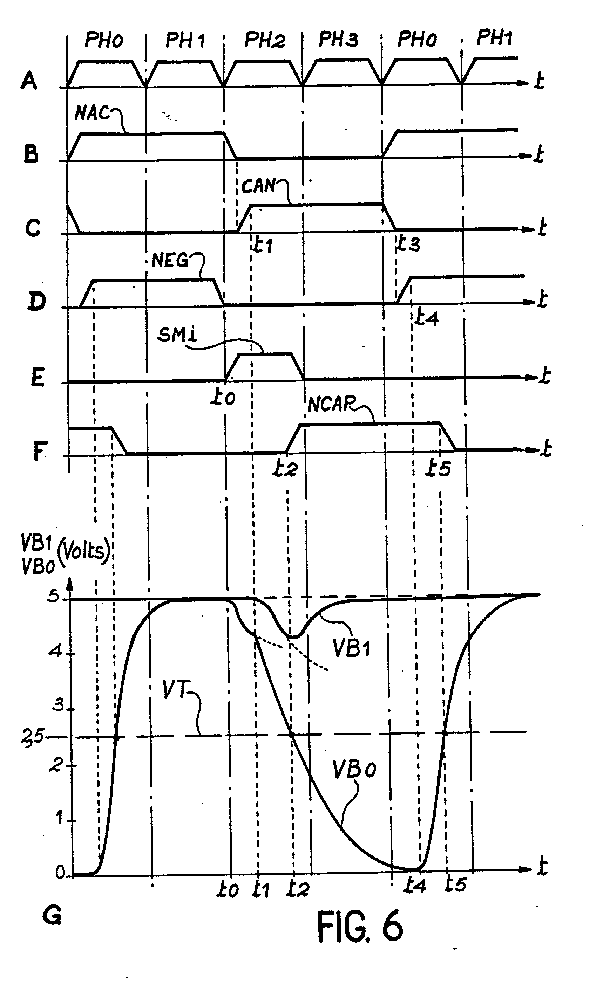

Les chronogrammes représentés aux figures 5 et 6 vont permettre d'expliquer le fonctionnement détaillé du dispositif d'amplification selon l'invention selon deux variantes de réalisation du circuit de précharge.

Les chronogrammes A à G de la figure 5 représentent les variations en fonction du temps des différents signaux qui ont été déjà mentionnés précédemment.

Le chronogramme A représente les quatre

phases d'horloge PH0, PH1, PH2, PH3 intervenant dans le fonctionnement d'une unité centrale d'ordinateur. Le chronogramme B représente le signal présent sur la ligne NAC décrit à la figure 3. Le chronogramme C représente le signal CAN issu de la bascule 44, 45. Le chronogramme D représente le signal complémentaire NEG du signal de commande EG de la précharge. Le chronogramme E représente le signal de sélection SMi d'un point mémoire connecté aux lignes de bit. Le chronogramme F représente le signal complémentaire NCAP du signal de commande CAP issu du détecteur 3 représenté aux figures 1 et 2. Enfin le chronogramme G représente les variations en fonction du temps des tensions VB0 et VB1 présentes respectivement sur les lignes de bit B0, B1.

La variante de réalisation correspondant au fonctionnement représenté à la figure 5 correspond au cas où le circuit de précharge est constitué simplement par un transistor d'égalisation.

Peu de temps avant l'apparition de la phase PH2, à l'instant t0, les lignes de bit B0, B1 sont préchargés à une valeur constante égale à la moitié de la tension d'alimentation Vdd. Sur le chronogramme G, il a été supposé que cette tension Vdd était égale à 5 volts. Après l'instant t0, le signal PH2 devenant actif, le circuit de commande de sélection 2 délivre le signal SMi à l'entrée de sélection du point mémoire 1. Ce signal provoque la mise en communication des circuits de mémorisation du point mémoire 1 avec les lignes de bits B0, B1. Il en résulte que la tension d'une des lignes de bits va augmenter et celle de l'autre ligne de bit va diminuer. Sur le chronogramme G, il a été supposé que la tension VB1 augmentait tandis que la tension VB0 diminuait, indiquant une valeur 1 logique mémorisée.

D'autre part, à l'apparition du signal d'horloge PH2, le transistor 42 du circuit de la figure 3 devient conducteur ce qui provoque la décharge de la ligne NAC. Il en résulte que la sortie CAN de la bascule 44, 45 passe à la valeur 1 logique à l'instant t1, quelque temps après l'instant t0. Le signal CAN active alors à l'instant t1 le premier amplificateur AN ce qui provoque la décharge accélérée de la ligne de bit B0 par l'intermédiaire du transistor N1.

Le second transistor N2 étant alors bloqué ou, tout au moins, moins conducteur que le transistor N1, la tension VB1 de la ligne B1 reste constante ou décroît moins vite que celle de la ligne B0. Lorsque la tension VB0 atteint à l'instant t2 la valeur VT de seuil de déclenchement du détecteur 3, ce dernier délivre un signal CAP activant le second amplificateur AN. Il en résulte que le transistor P2 du second amplificateur AP devient conducteur. La ligne B1 est alors chargée à la tension d'alimentation Vdd par l'intermédiaire des transistors P3 et P2. Ainsi, à partir de l'instant t2, la tension VB1 augmente rapidement jusqu'à la tension d'alimentation Vdd. Simultanément, la tension VB0 continue à diminuer jusqu'à 0. Cette amplification continue durant toute la phase PH3 jusqu'à la phase suivante pH0. Le signal PH0 rend alors conducteur le transistor 43 de la figure 3 provoquant ainsi la précharge de la ligne NAC à la tension d'alimentation. La bascule 44, 45 change ensuite d'état et le signal CAN prend la valeur 0 à l'instant t3. Le signal de sortie EG du circuit de commande d'égalisation 5 prend alors la valeur 0 à l'instant t4. Il en résulte l'activation du transistor d'égalisation 57 du circuit de précharge PC et la ligne B1 se décharge tandis que la ligne B0 se charge jusqu'à une valeur commune environ égale à la moitié de la tension d'alimentation. Cette égalisation se poursuit durant toute la phase suivante PH1.

Il est intéressant de noter que le second amplificateur AP contribue à la précharge entre les instants t4 et t5, ce qui est rendu possible précisément par l'asservissement de son déclenchement par la tension des lignes de bit et non pas par un signal d'horloge extérieur.

Selon le fonctionnement décrit précédemment, nous constatons que les deux amplificateurs AN et AP travaillent symétriquement. Or, si ces amplificateurs sont réalisés en technologie MOS, il est alors nécessaire de prévoir des transistors à canal p aussi performants que des transistors à canal n pour constituer les deux amplificateurs AN et AP. Or des transistors MOS à canal p ayant des performances équivalentes à des transistors MOS à canal n sont beaucoup plus volumineux. Il est donc souhaitable de concevoir un dispositif tenant compte de ces contraintes technologiques. Il est donc plus avantageux de faire travailler davantage l'amplificateur AN que l'amplificateur AP, ce qui permettra d'utiliser des transistors à canal p moins performants. Pour cela, et selon une autre caractéristique de l'invention, les lignes de bits ne sont plus préchargées à une tension moitié de la tension d'alimentation Vdd mais à la tension Vdd ellemême. Le circuit de précharge PC qui a été décrit à la figure 4 permet cette précharge à la tension d'alimentation.

Les chronogrammes de la figure 6 permettent d'expliquer le fonctionnement du dispositif d'amplification dans ce dernier cas. Les chronogrammes A à G ont la même signification que ceux de la figure 5. Le fonctionnement sera le suivant. Comme dans le cas de la figure 5, au cours de la phase PH2, à l'instant t1 le premier amplificateur AN est activé. Comme précédemment, la ligne B0 se décharge par l'intermédiaire des transistors N1 et N3. Compte-tenu de la précharge à la tension Vdd l'autre ligne B1 se décharge également mais moins rapidement que la ligne B0. Lorsque la tension VB0 atteint le seuil VT, l'amplificateur AP est activé et la ligne B1 est rechargée à la tension d'alimentation Vdd par l'intermédiaire des transistors P2 et P3 du second amplificateur AP. Finalement, la ligne B1 se charge à la tension d'alimentation et la ligne B0 prend la tension de masse. Comme précédemment, à l'instant t4 de la phase PH0, le signal de précharge EG active le circuit de précharge PC. La ligne B1 reste alors à la tension d'alimentation tandis que la ligne B0 se charge à cette même tension. Selon cette variante également, le second amplificateur AP contribue à la précharge.

Comme nous pouvons le constater d'après l'allure des courbes VB1 et VB0 du chronogramme G de la figure 6 et contrairement à la variante précédente, le premier amplificateur AN a un travail beaucoup plus important que le second amplificateur AP pendant la phase de lecture. L'amplificateur AP n'a plus qu'un rôle auxiliaire qui autorise l'utilisation de transistor PMOS beaucoup moins puissant que dans le cas d'une précharge à une tension inférieure à la tension d'alimentation. En contre-partie, la précharge PC exige davantage d'énergie. Mais cela ne nuit pas aux performances globales du circuit dont le paramètre le plus important est la rapidité de lecture et d'amplification des valeurs mémorisées.

L'exposé qui précède montre que l'invention est particulièrement bien adaptée à une réalisation exécutée en totalité avec la technologie CMOS ou analogue. Bien entendu des modifications évidentes peuvent être apportées à l'invention. En particulier il est possible d'utiliser des sources d'alimentation ayant des tensions négatives ou remplacer un transistor quelconque par plusieurs transistors de même type en parallèle.

**Revendications**

1. Dispositif pour amplifier la différence de tension entre deux lignes de bit (B0, B1), ledit dispositif étant associé à une source de tension d'alimentation et comprenant un premier amplificateur (AN) sensible aux tensions (VB0, VB1) desdites lignes de bit et qui, lorsqu'il est activé par un signal de commande (CAN), met en communication la ligne de bits ayant la plus faible tension avec la borne de plus faible potentiel de ladite source de tension, ledit dispositif étant caractérisé en ce qu'il comprend un circuit de détection (3) délivrant un signal de sortie (CAP) lorsque la tension d'une des lignes de bit est inférieure à une valeur déterminée (VT) et en ce que ledit signal de sortie (CAP) commande l'activation d'un second amplificateur (AP) sensible auxdites tensions (VB0, VB1) qui, lorsqu'il est activé, met en communication la ligne de bit ayant la tension la plus élevée avec la borne de plus fort potentiel (Vdd) de ladite source d'alimentation.

2. Dispositif selon la revendication précédente caractérisé en ce que le dispositif de détection (3) est constitué par une porte ET à deux entrées reliées respectivement aux deux lignes de bit (B0, B1).

3. Dispositif selon la revendication précédente caractérisé en ce que le premier et le second amplificateur (AN, AP) sont constitués chacun par un premier transistor à effet de champs (N1, P1) et un second transistor à effet de champs (N2, P2), les drains desdits transistors étant reliés à la première, respectivement, seconde ligne de bit (B0, B1), les sources desdits premier et second transistors étant reliées au drain d'un troisième transistor à effet de champs (N3, P3), le premier amplificateur (AN) étant constitué par des transistors à canal n, le troisième transistor (N3) dudit premier amplificateur (AN) ayant sa source reliée à la borne d'alimentation ayant le plus faible potentiel, le second amplificateur (AP) étant constitué par des transistors à canal p, le troisième transistor (P3) dudit second amplificateur (AP) ayant sa source reliée à la borne d'alimentation ayant le plus fort potentiel, la grille dudit troisième transistor (P3) étant reliée à la sortie du circuit de détection (3).

4. Dispositif selon la revendication précédente caractérisé en ce que les transistors constituant le premier et le second amplificateur (AN, AP) sont des transistors MOS et en ce que le dispositif de détection (3) est constitué par une porte NON ET (DP1, DN1, DP2, DN2) CMOS dont la sortie est reliée à l'entrée d'un inverseur (DP3, DN3) CMOS, la sortie dudit inverseur étant reliée à la grille du troisième transistor (P3) dudit second amplificateur (AP).

5. Dispositif selon l'une des revendications précédentes caractérisé en ce que les lignes de bit étant reliées aux bornes de sortie d'un point mémoire ou d'un circuit logique (1) commandé par un signal de sélection (SMi), le signal de commande (CAN) du premier amplificateur (AN) est généré par un circuit d'activation (4) sensible à un signal de lecture (RD), ledit circuit d'activation (4) délivrant le signal de commande (CAN) du premier amplificateur (AN) un certain temps après l'apparition du signal de sélection (SMi) du point mémoire ou du circuit logique (1).

6. Dispositif selon la revendication précédente caractérisé en ce que le signal de sélection (SMi) du point mémoire ou du circuit logique (1) est synchronisé par un signal d'horloge (PH2) et en ce que le circuit d'activation (4) est constitué par un circuit fonctionnant comme une porte ET (41) à deux entrées recevant le signal de commande de lecture (RD) et le signal d'horloge (PH2), la sortie de la porte ET (41) étant reliée à la grille d'un transistor à effet-de champs à canal n (42), dont la source est reliée à la borne d'alimentation de plus faible potentiel, le drain dudit transistor (42) étant relié à l'entrée d'une bascule constituée par deux inverseurs (44,45) montés en tête-bêche, la sortie de ladite bascule délivrant le signal de commande (CAN) du premier amplificateur (AN).

7. Dispositif selon la revendication précédente caractérisé en ce que l'entrée de la bascule (44, 45) est également reliée au drain d'un transistor à effet de champs à canal p (43) dont la source est reliée à la borne d'alimentation de plus fort potentiel (Vdd), la grille dudit transistor (43) étant reliée au signal complémentaire (NPH0) d'un second signal d'horloge (PH0).

8. Dispositif selon la revendication précédente caractérisé en ce que l'entrée de la bascule (44, 45) est reliée au drain d'au moins un autre transistor à effet de champs à canal n (46) dont la source est reliée à la borne d'alimentation de plus faible potentiel, la grille dudit transistor (46) recevant un signal de commande de transfert (T) qui, lorsqu'il est actif, permet l'activation du premier amplificateur (AN) indépendamment d'un signal de commande de lecture (RD).

9. Dispositif selon la revendication 7 caractérisé en ce qu'il comprend un dispositif de précharge (PC) pour charger les lignes de bits (B0, B1) à une tension déterminée et en ce que le dispositif de précharge (PC) est activé si le signal de commande (CAN) du premier amplificateur (AN) est inactif et si le second signal d'horloge (PH0) est actif.

10. Dispositif selon la revendication précédente caractérisé en ce que le circuit de précharge (PC) comprend deux transistors (55, 56) à effet de champs à canal p dont les sources sont reliées à la borne d'alimentation de plus fort potentiel (Vdd) et dont les drains sont reliés respectivement aux deux lignes de bits (B0, B1), un troisième transistor à effet de champs à canal p (57) ayant ses électrodes de courant reliés aux deux lignes de bits (B0, B1), les grilles desdits transistors (55, 56, 57) recevant un signal de commande de précharge (EG) issu d'un dispositif de commande de précharge (5).

11. Dispositif pour amplifier la différence de tension entre deux lignes de bit (B0, B1), ledit dispositif étant associé à une source de tension d'alimentation et comprenant un premier amplificateur (AP) sensible aux tensions (VB0, VB1) desdites lignes de bit et qui, lorsqu'il est activé par un signal de commande (CAN), met en communication la ligne de bits ayant la plus forte tension avec la borne de plus fort potentiel (Vdd) de ladite source de tension, ledit dispositif étant caractérisé en ce qu'il comprend un circuit de détection (3) délivrant un signal de sortie (CAP) lorsque la tension d'une des lignes de bit est supérieure à une valeur déterminée (VT) et en ce que ledit signal de sortie (CAP) commande l'activation d'un second amplificateur (AN) sensible auxdites tensions (VB0, VB1) qui, lorsqu'il est activé, met en communication la ligne de bit ayant la tension la plus faible avec la borne de plus faible potentiel de ladite source d'alimentation.

**Patentansprüche**

1. Vorrichtung zum Verstärken des Spannungsunterschieds zwischen zwei Bitleitungen (B0, B1), wobei diese Vorrichtung einer Quelle für die Versorgungsspannung zugeordnet ist und einen ersten Verstärker (AN) umfaßt, der für die Spannungen (VB0, VB1) der genannten Bitleitungen empfindlich ist und wenn er durch ein Steuersignal (CAN) aktiviert - wird die Bitleitung mit der schwächsten Spannung mit der Klemme mit dem schwächsten Potential der genannten Spannungsquelle in Verbindung setzt, wobei diese Vorrichtung dadurch gekennzeichnet ist, daß sie eine Erfassungsschaltung (3) umfaßt, die ein Ausgangssignal (CAP) abgibt, wenn die Spannung einer der Bitleitungen einen vorbestimmten Wert (VT) unterschreitet, und daß das genannte Ausgangssignal (CAP) die Aktivierung eines zweiten Verstärkers (AP) steuert, der für die genannten Spannungen (VB0, VB1) empfindlich ist und in seinem Aktivierungszustand die Bitleitung mit der höchsten Spannung mit der Klemme mit dem höchsten Potential (Vdd) der genannten Versorgungsspannung in Verbindung setzt.

2. Vorrichtung nach dem vorstehenden Anspruch, dadurch gekennzeichnet, daß die Erfassungsschaltung (3) aus einem AND-Gate mit zwei Eingängen, die jeweils mit den beiden Bitleitungen (B0, B1) verbunden sind, besteht.

3. Vorrichtung nach dem vorstehenden Anspruch, dadurch gekennzeichnet, daß der erste Verstärker (AN) sowie der zweite Verstärker (AP) aus einem ersten Feldeffekt-Transistor (N1, P1), bzw. aus einem zweiten Feldeffekt-Transistor (N2, P2) bestehen, wobei die Drains dieser Transistoren mit der ersten Bitleitung (B0), bzw. mit der zweiten Bitleitung (B1) verbunden sind, die Sources des ersten Transistors sowie des zweiten Transistors mit dem Drain eines dritten Feldeffekt-Transistor (N3, P3) verbunden sind, der erste Verstärker (AN) aus p- Kanal-Transistoren besteht, die Source des dritten Transistors (N3) des genannten ersten Verstärkers (AN) mit der Versorgungsklemme des schwächsten Potentials verbunden ist, wobei der zweite Verstärker (AP) aus p-Kanal-Transistoren besteht, die Source des dritten Transistors (P3) des genannten zweiten Verstärkers (AP) mit der Versorgungsklemme, die das höchste Potential aufweist, verbunden ist, wobei das Gate des genannten dritten Transistors (p3) mit dem Ausgang der Erfassungsschaltung (3) verbunden ist.

4. Vorrichtung nach dem vorstehenden Anspruch, dadurch gekennzeichnet, daß die den ersten Verstärker (AN) sowie den zweiten Verstärker (AP) bildenden Transistoren MOS-Transistoren sind und daß die Erfassungsschaltung (3) aus einem CMOSNAND-Gate (DP1, DN1, DP2, DN2) besteht, dessen Ausgang mit dem Eingang eines CMOS-Schalters (DP3, DN3) verbunden ist, wobei der Ausgang dieses Schalters mit dem Gate des dritten Transistors (P3) dieses zweiten Verstärkers (AP) verbunden ist.

5. Vorrichtung nach einem der vorstehenden Ansprüche, dadurch gekennzeichnet, daß die Bitleitungen mit den Ausgangsklemmen eines durch ein Selektionssignal (SMi) gesteuerten Speicherpunktes oder einer durch ein Steuersignal (SMi) gesteuerten Logikschaltung (1) verbunden sind und daß das Steuersignal (CAN) des ersten Verstärkers (AN) von einer Aktivierungsschaltung (4) abgegeben wird, die für ein Auslesesignal (RD) empfindlich ist, wobei diese Aktivierungsschaltung (4) das Steuersignal (CAN) des ersten Verstärkers (AN) eine gewisse Zeit nach dem Auftreten des Selektionssignals (SMi) für den Speicherpunkt oder die Logikschaltung (1) abgibt.

6. Vorrichtung nach dem vorstehenden Anspruch, dadurch gekennzeichnet, daß das Selektionssignal (SMi) für den Speicherpunkt oder die Logikschaltung (1) von einem Taktsignal (PH2) synchronisiert wird und daß die Aktivierungschaltung (4) aus einer Schaltung besteht, die wie ein AND-Gate (41) mit zwei Eingängen arbeitet, das das Auslesesteuersignal (RD) sowie das Taktsignal (PH2) empfängt, wobei der Ausgang des AND-Gates (41) mit dem Gate eines n-Kanal-Feldeffekttransistors (42) verbunden ist, dessen Source mit der Versorgungsklemme mit der schwächsten Spannung verbunden ist, wobei der Drain des genannten Transistors (42) mit dem Eingang einer Kippschaltung verbunden ist, die aus zwei entgegengesetzt angeordneten Invertern (44, 45) besteht, wobei der Ausgang der genannten Kippschaltung das Steuersignal (CAN) des ersten Verstärkers (AN) abgibt.

7. Vorrichtung nach dem vorstehenden Anspruch, dadurch gekennzeichnet, daß der Eingang der Kippschaltung (44, 45) auch mit dem Drain eines p-Kanal-Feldeffekttransistors (43) verbunden ist, dessen Source mit der Versorgungsklemme mit der höchsten Spannung (Vdd) verbunden ist, wobei das Gate des genannten Transistors (43) mit dem Komplementärsignal (NPH0) eines zweiten Taktsignals (PH0) verbunden ist.

8. Vorrichtung nach dem vorstehenden Anspruch, dadurch gekennzeichnet, daß der Eingang der Kippschaltung (44, 45) mit dem Drain wenigstens eines weiteren n-Kanal-Feldeffekttransistors (46) verbunden ist, dessen Source mit der Versorgungsklemme mit der schwächsten Spannung verbunden ist, wobei das Gate des genannten Transistors (46) ein Überführungssteuersignal (T) empfängt, das in seinem Aktivzustand die Aktivierung des ersten Verstärkers (AN) unabhängig von einem Signal (RD) zur Steuerung des Auslesens ermöglicht.

9. Vorrichtung nach Anspruch 7, dadurch gekennzeichnet, daß sie eine Vorladevorrichtung (PC) zum Vorladen der Bitleitungen (B0, B1) auf eine vorbestimmte Spannung umfaßt und daß die Vorladevorrichtung (PC) aktiviert wird, wenn das Signal (CAN) zur Steuerung des ersten Verstärkers (AN) inaktiv und das zweite Taktsignal (PH0) aktiv ist.

10. Vorrichtung nach dem vorstehenden Anspruch, dadurch gekennzeichnet, daß die Vorladeschaltung (PC) zwei p-KanalFeldeffekttransistoren (55, 56) umfaßt, deren Sources mit der Versorgungsklemme mit der höchsten Spannung (Vdd) verbunden sind und deren Drains jeweils mit den beiden Bitleitungen (B0, B1) verbunden sind, wobei die Stromelektroden eines dritten p-Kanal-Feldeffekttransistors· (57) mit den beiden Bitleitungen (B0, B1) verbunden sind und die Gates der genannten Transistoren (55, 56, 57) ein aus einer Vorladesteuervorrichtung (5) stammendes Vorladesteuersignal (EG) empfangen.

11. Vorrichtung zum Verstärkern des Spannungsunterschiedes zwischen zwei Bitleitungen (B0, B1),. wobei die genannte Vorrichtung einer Quelle für die Versorgungsspannung zugeordnet ist und einen ersten Verstärker (AP) umfaßt, der für die Spannungen (VB0, VB1) der genannten Bitleitungen empfindlich ist und, wenn er durch ein Steuersignal (CAN) aktiviert wird, die Bitleitung mit der höchsten Spannung mit der Klemme mit der höchsten Spannung (Vdd) der genannten Spannungsquelle in Verbindung setzt, wobei diese Vorrichtung dadurch gekennzeichnet ist, daß sie eine Erfassungsschaltung (3) umfaßt, die ein Ausgangssignal (CAP) abgibt, wenn die Spannung einer dieser Bitleitungen einen vorbestimmten Wert (VT) überschreitet, und daß das genannte Ausgangssignal (CAP) die Aktivierung eines zweiten Verstärkers (AN) steuert, welcher für die genannten Spannungen empfindlich ist und in seinem Aktivzustand die Bitleitung mit der schwächsten Spannung mit der Klemme mit der schwächsten Spannung der genannten Versorgungsquelle in Verbindung setzt.

**Claims**

1. A device for amplifying the difference in voltage between two bit lines (B0, B1), said device being associated with a source of supply voltage and including a first amplifier (AN) sensitive to the voltages (VB0, VB1) of said bit lines and which, when it is activated by a control signal (CAN), puts the bit line having the lowest voltage in communication with the terminal having the lowest potential of said voltage source, said device being characterized in that it includes a detection circuit (3) delivering an output signal (CAP) when the voltage of one of the bit lines is lower than a predetermined value (VT) and in that said output signal (CAP) controls the activation of a second amplifier (AP) sensitive to said voltages (VB0, VB1) which, when it is activated, puts the bit line having the highest voltage in communication with the terminal having the highest potential (Vdd) of said supply source.

2. A device according to the preceding claim, characterized in that the detection device (3) comprises an AND gate having two inputs connected respectively to the two bit lines (B0, B1).

3. A device according to the preceding claim, characterized in that the first and the second amplifier (AN, AP) each comprise a first field-effect transistor (N1, P1) and a second field-effect transistor (N2, P2), the drains of said transistors being connected to the first and second bit line (B0, B1), respectively, the sources of said first and second transistors being connected to the drain of a third field-effect transistor (N3, P3), the first amplifier (AN) comprising n-channel transistors, the third transistor (N3) of said first amplifier (AN) having its source connected to the supply terminal having the lowest potential, the second amplifier (AP) comprising p-channel transistors, the third transistor (P3) of said second amplifier (AP) having its source connected to the supply terminal having the highest potential, the gate of said third transistor (P3) being connected to the output of the detection circuit (3).

4. A device according to the preceding claim, characterized in that the transistors comprising the first and the second amplifier (AN, AP) are MOS transistors, and that the detection device (3). comprises a CMOS NAND gate (DP1, DN1, DP2, DN2), the output of which is connected to the input of a CMOS inverter (DP3, DN3), the output of said inverter being connected to the gate of the third transistor (P3) of said second amplifier (AP).

5. A device according to one of the preceding claims, characterized in that the bit lines are connected to the output terminals of a memory point or logic circuit (1) controlled by a selection signal (SMi), the control signal (CAN) of the first amplifier (AN) is generated by an activation circuit (4) sensitive to a reading signal (RD), said activation circuit (4) delivering the control signal (CAN) of the first amplifier (AN) a certain period of time after the appearance of the signal (SMi) for selection of the memory point or logic circuit (1).

6. A device according to the preceding claim, characterized in that the signal (SMi) for selection of the memory point or logic circuit (1) is synchronized by a clock signal (PH2), and that the activation circuit (4) comprises a circuit functioning as an AND gate (41) having two inputs receiving the reading control signal (RD) and the clock signal (PH2), the output of the AND gate (41) being connected to the gate of an n-channel field-effect transistor (42), the source of which is connected to the supply terminal having the lowest potential, the drain of said transistor (42) being connected to the input of a multivibrator consisting of two inverters (44, 45) assembled head-to-tail, the output of said multivibrator delivering the control signal (CAN) of the first amplifier (AN).

7. A device according to the preceding claim, characterized in that the input of the multivibrator (44, 45) is likewise connected to the drain of a p-channel field-effect transistor (43), the source of which is connected to the supply terminal having the highest potential (Vdd), the gate of said transistor (43) being connected to the complementary signal (NPH0) of a second clock signal (PH0).

8. A device according to the preceding claim, characterized in that the input of the multivibrator (44, 45) is connected to the drain of at least one other n-channel field-effect transistor (46), the source of which is connected to the supply terminal having the lowest potential, the gate of said transistor (46) receiving a transfer control signal (T) which, when it is active, permits the activation of the first amplifier independently of a reading control signal (RD).

9. A device according to the claim 7, characterized in that it includes a precharging device (PC) for charging the bit lines (B0, B1) to a predetermined voltage, and in that the precharging device (PC) is activated if the control signal (CAN) of the first amplifier (AN) is inactive and if the second clock signal (PH0) is active.

10. A device according to the preceding claim, characterized in that the precharging circuit (PC) includes two p-channel field effect transistors (55, 56), the source of which are connected to the supply terminal having the highest potential (Vdd) and the drains of which are connected, respectively, to the two bit lines (B0, B1), a third p-channel field-effect transistor (57) having its current electrodes connected to the two bit lines (B0, B1), the gates of said transistors (55, 56, 57) receiving a precharging control signal (EG) emitted by a precharging control device (5).

11. A device for amplifying the voltage difference between two bit lines (B0, B1), said device being associated with a source of supply voltage and including a first amplifier (AP) sensitive to the voltages (VB0, VB1) of said bit lines and which, when it is activated by a control signal (CAN), puts the bit line having the highest voltage in communication with the terminal having the highest potential (Vdd) of said voltage source, said device being characterized in that it includes a detection circuit (3) delivering an output signal (CAP) when the voltage of one of the bit lines is greater than a predetermined value (VT) and in that said output signal (CAP) controls the activation of a second amplifier (AN) sensitive to said voltages (VB0, VB1), which, when it is activated, puts the bit line having the lowest voltage in communication with the terminal having the lowest potential of said supply source.

FIG. 1

EP 0 262 013 B1

FIG. 2

FIG. 3

FIG. 4

FIG. 5

FIG. 6